Europäisches Patentamt

European Patent Office

Office européen des brevets

(11) Publication number: **0 427 565 A2**

## (12) EUROPEAN PATENT APPLICATION

(21) Application number: 90312287.7

(22) Date of filing: 09.11.90

(51) Int. Cl.5: **H01L 27/02, H01L 27/092**

(30) Priority: 10.11.89 JP 292627/89
08.10.90 JP 271555/90

(43) Date of publication of application:
**15.05.91 Bulletin 91/20**

(84) Designated Contracting States:
**DE FR GB IT NL**

(71) Applicant: **SEIKO EPSON CORPORATION**
**4-1, Nishishinjuku 2-chome**
**Shinjuku-ku Tokyo(JP)**

(72) Inventor: **Sasaki, Minoru, c/o Seiko Epson**
**Corporation**
**3-5 Owa 3-chome**
**Suwa-shi, Nagano-ken(JP)**

(74) Representative: **Caro, William Egerton et al**
**J. MILLER & CO. Lincoln House 296-302 High**
**Holborn**
**London WC1V 7JH(GB)**

(54) **Integrated circuit having MIS transistor.**

(57) The present invention provides an integrated circuit having at least one MIS transistor ($T_n$, $T_p$), in which a gate electrode ($G_n$, $G_p$) is arranged to connected to a power supply potential ($V_{dd}$, $V_{ss}$) through a protective resistor ($R_1$, $R_2$). The integrated circuit has a first contact diffusion region ($4_n$, $4_p$) formed within a semi-conductor substrate (1) or within a well (2) in the semi-conductor substrate and arranged to make contact with the power supply potential, and a second contact diffusion region (25, 28, 35, 38) formed within the semi-conductor substrate or the well at a position isolated from the first contact diffusion region and arranged in electrical contact with the gate electrode. That region of the semi-conductor substrate or well between the first and second contact diffusion regions substantially constitutes a resistance region of the protective resistor.

FIG 1

## INTEGRATED CIRCUIT HAVING MIS TRANSISTOR

This invention relates to an integrated circuit having at least one metal-insulator semi-conductor (MIS) transistor, whose gate electrode is arranged to be connected to a power supply potential through a protective resistor.

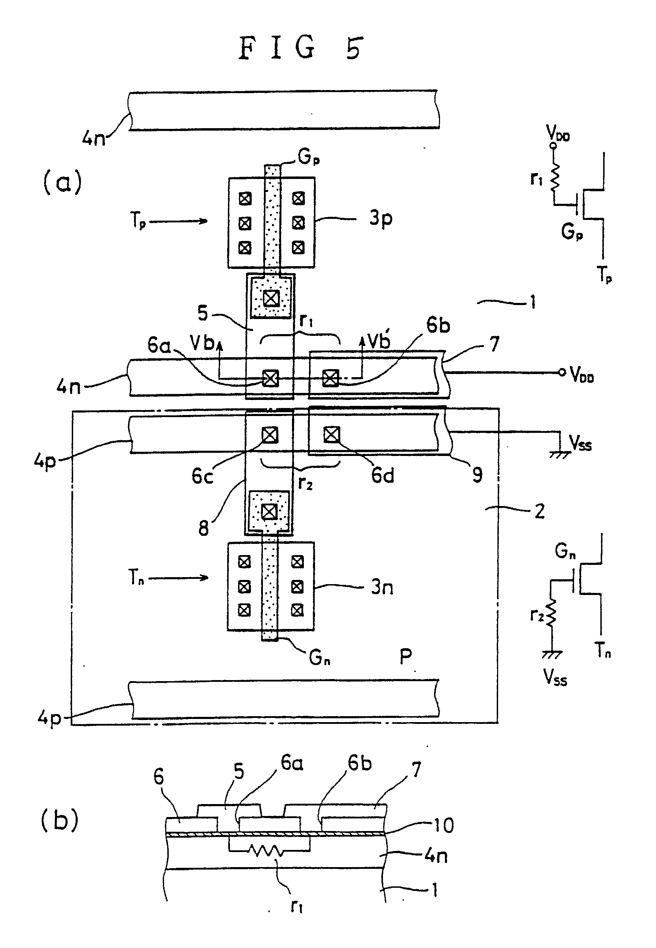

A conventional C-MOS (complementary insulated gate field effect transistor) integrated circuit fabricated using a self-aligned silicide process is shown in Figure 5 and has a p-type well 2 formed on the main surface of an n-type semi-conductor substrate 1, polycide structure gate electrodes $G_p$ and $G_n$, each comprising a polycrystalline silicon film and a film of a high melting point metal disilicide such as $TiSi_2$ (titanium disilicide), formed on the n-type semi-conductor substrate 1 and the p-type well 2 via gate insulation films, a p-type source/drain region $3_p$ and an n-type source/drain region $3_n$ formed in a self-aligned manner by masking the gate electrode $G_p$ and the gate electrode $G_n$, a channel stopper $4_p$ heavily doped with p-type impurity formed within the p-type well 2 for preventing parasitic MOS and a channel stopper $4_n$ heavily doped with n-type impurity formed on the n-type semi-conductor substrate 1 for preventing latch up. There is thus provided an n-channel MOS transistor $T_n$ comprising the gate electrode $G_n$ and the n-type source/drain region $3_n$ of the p-type well 2, and a p-channel MOS transistor $T_p$ comprising the gate electrode $G_p$ and the p-type source/ drain region $3_p$ on the n-type semi-conductor substrate 1. In the self-aligned silicide process, the gate resistance, the contact resistance and the diffusion resistance are reduced by overlaying the polycrystalline silicon of the gates, the source/drain regions $3_p$, $3_n$ and the channel stoppers $4_n$, $4_p$ with titanium or other high melting point metal in a self-aligned manner and then conducting heat treatment to form a high melting point metal disilicide film 10 in a self-aligned manner.

In an integrated circuit having various circuit structures, however, in order to realise a function such as that of, for example, an input protection diode or a pull-up (or pull-down) resistor, it is frequently the practice to pull the gate electrode of the MOS (MIS) transistor up or down to the power supply potential (high potential $V_{dd}$, low potential $V_{ss}$), in accordance with the purpose at hand. In this case, it has generally been the practice to connect the gate electrode with the power supply potential through a protective resistor having a relatively high resistance value for the purpose of preventing breakdown of the gate insulation film by power supply turn on noise, surge voltage or other such noise.

In the C-MOS integrated circuit illustrated in Figure 5, the structure of the protective resistor on the side of the p-channel MOS transistor $T_p$ comprises an aluminium wire 5 in electrical contact with the gate electrode $G_p$ of the p-channel MOS transistor $T_p$ and in conductive contact with the channel stopper $4_n$ through a contact hole 6a of a field oxide film 6, and an aluminium wire 7 in conductive contact with the channel stopper $4_n$ through a contact hole 6b at a position isolated from the contact hole 6a and connected with the high potential $V_{dd}$, so that as shown in Figure 5 (b) part of the channel stopper $4_n$ constituted by the diffusion region between the contact holes 6a, 6b substantially constitutes a protective resistor $r_1$. On the other hand, the structure of the protective resistor on the side of the n-channel MOS transistor $T_n$ comprises an aluminium wire 8 in electrical contact with the gate electrode $G_n$ of the p-channel MOS transistor $T_n$ and in conductive contact with the channel stopper $4_p$ through a contact hole 6c of the field oxide film, and an aluminium wire 9 in conductive contact with the channel stopper $4_p$ through a contact hole 6d at a position isolated from the contact hole 6c and connected with ground potential (the low power supply potential $V_{ss}$), so that part of a channel stopper $4_p$ provided by the diffusion region between the contact holes 6c, 6d substantially constitutes a protective resistor $r_2$.

Thus, the gate electrode $G_p$ of the p-channel MOS transistor $T_p$ is pull-up connected to the high potential $V_{dd}$ through the protective resistor $r_1$ while the gate electrode $G_n$ of the n-channel MOS transistor $T_n$ is pull-down connected with the ground voltage $V_{ss}$ through the protective resistor $r_2$, whereby any power supply noise that arises is partially absorbed by the protective resistors $r_1$, $r_2$.

As shown in Figure 5 (b), however, in the aforesaid integrated circuit fabricated using the self-aligned silicide process, the channel stoppers $4_p$, $4_n$ have the high melting point metal disilicide film 10 on the surface thereof and, comprising heavily doped diffusion regions with an impurity content approximately on a level with that of the source/drain regions, have low resistivity. Notwithstanding that it is preferable for the protective resistors $r_1$, $r_2$ to have high resistance values, they actually have very low resistance because of the low resistivity of the diffusion regions. There is thus a risk of the gate insulator film being broken down by power supply noise or the like. As the gate breakdown voltage of a gate electrode produced according to the self-aligned silicide process is extremely low, it is necessary to set the resistance of the protective resistors at a high value.

While the resistance of the protective resistors

$r_1$, $r_2$ can be increased by increasing the length of the diffusion resistance regions (i.e. by increasing the distances between the contact holes 6a, 6b and between the contact holes 6c, 6d), this increases the size of the protective resistors $r_1$, $r_2$ and runs counter to the aim of realising finer features and higher packing density.

One object of the invention is to overcome the aforesaid problem by providing an integrated circuit having at least one MIS transistor, in which a protective resistor comprising a diffusion resistance having a relatively large resistance value can be realised even when a channel stopper or other such low resistivity diffusion region formed by the self-aligned silicide process is present, whereby breakdown of the gate insulation film can be prevented even if the gate electrode is connected to the power supply potential.

In accordance with the present invention, there is provided an integrated circuit having at least one MIS transistor in which a gate electrode is arranged to be connected to a power supply potential through a protective resistor, characterised by a first contact diffusion region formed within a semi-conductor substrate or within a well in the semi-conductor substrate and arranged to make contact with the power supply potential, and a second contact diffusion region formed within the semi-conductor substrate or the well at a position isolated from the first contact diffusion region and arranged in electrical contact with the gate electrode, the region of the semi-conductor substrate or well between the first and second contact diffusion regions substantially constituting a resistance region of the protective resistor.

Generally, the impurity content of the semi-conductor substrate and the well therein is low and, as a result, the resistivity is high. In an integrated circuit, to which the self-aligned silicide process has been applied, for example, a high melting point metal disilicide film according to the self-aligned silicide process is also formed on the surface of the first and second contact diffusion regions, with the result that the resistivity of the two contact diffusion regions is low. On the other hand, the semi-conductor substrate and the well formed therein are not formed on their surfaces with a high melting point metal disilicide film and, moreover, the impurity content of the semi-conductor substrate and the well are low. They thus exhibit high resistivity.

Since the resistance region of the protective resistor is formed not in the channel stopper but in the semi-conductor substrate or the well, where the impurity content is relatively low, the resistance of the protective resistor is large. While in an integrated circuit employing the self-aligned silicide process the resistivity of the channel stopper region is markedly lowered by the presence of the high melting point metal disilicide film, the present invention, by taking advantage of the fact that the semi-conductor substrate and the well have relatively low impurity contents and are free of any high melting point metal disilicide film on the surfaces thereof, is able to provide a protective resistor with a high resistance value. This means that breakdown of the gate electrode film can effectively be prevented, and hence the invention makes a major contribution to the enhancement of semi-conductor device reliability.

The resistance region of the protective resistor is not a specially formed island like diffusion region but is conveniently substantially constituted within an unbounded sub-region of the semi-conductor substrate or the well. This sub-region can be relatively freely selected within the semi-conductor substrate or the well. Since the resistance value of the sub-region becomes larger when the substantial width thereof is small, the resistance region of the protective resistor can advantageously be provided in a narrow empty space sandwiched between diffusion regions, so long as it is possible to secure space for provision of the contact regions at the opposite ends.

While a diffusion region formed for exclusive use as an ohmic contact can be used as the first contact diffusion region, it is also possible to have the conventional channel stopper double as the first contact diffusion region.

Where the channel stopper is used as the first contact diffusion region, all that is necessary for employing an otherwise conventional structure is to form the second contact region making electrical contact with the gate electrode in the semi-conductor substrate or the well. Since the same structure serves as both the first contact diffusion region and the channel stopper, there is increased freedom as regards formation of the second contact diffusion region.

An important aspect of this formation of the resistor structure is the formation of the contact diffusion regions. This formation of the additional contact diffusion region requires only changes in the mask pattern and does not entail any increase in the number of processing steps.

The present invention will be described further, by way f example, with reference to the accompanying drawings, in which:-

Figure 1 is a top view of a C-MOS integrated circuit having MIS transistors according to one embodiment of this invention;

Figure 2 (a) is a sectional view in the plane IIa - IIa of Figure 1;

Figure 2 (b) is a sectional view in the plane IIb - IIb of Figure 1;

Figure 2 (c) is a sectional view in the plane IIc - IIc' of Figure 1;
Figure 2 (d) is a sectional view in the plane IId - IId' of Figure 1;
Figure 3 is a top view of a C-MOS integrated circuit having MIS transistors according to another embodiment of this invention;
Figure 4 (a) is a sectional view in the plane IVa - IVa' of Figure 3;
Figure 4 (b) is a sectional view in the plane IVb - IVb' of Figure 3;
Figure 5 (a) is a top view of a conventional C-MOS integrated circuit having MIS transistors; and
Figure 5 (b) is a sectional view in the plane Vb -Vb' of Figure 5 (a).

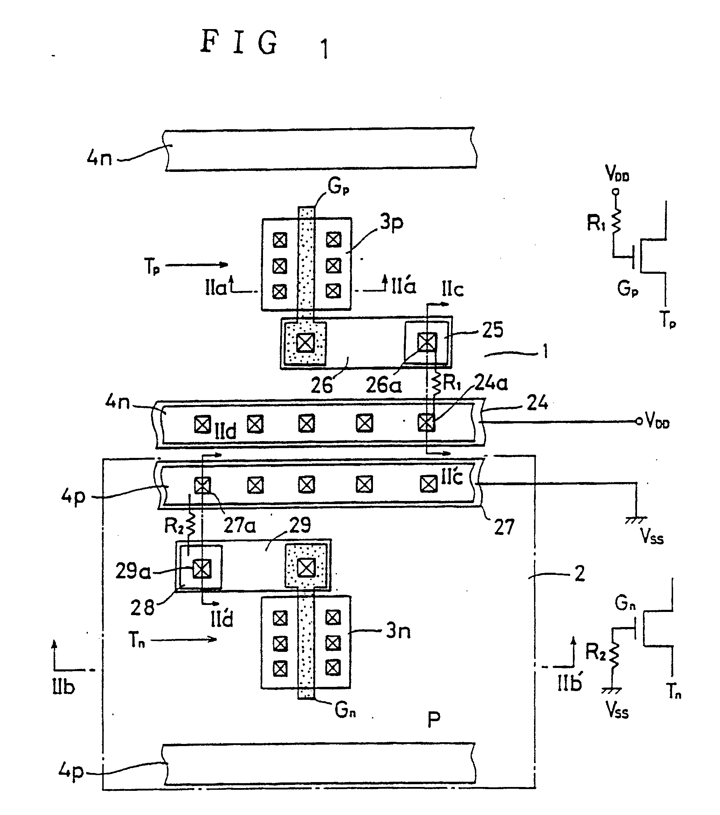

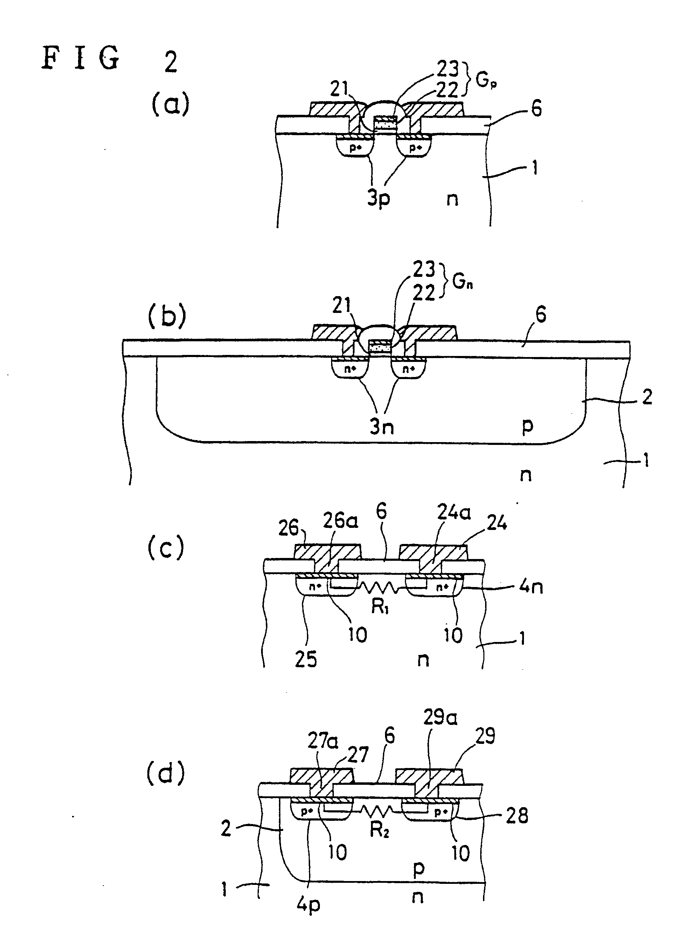

A first embodiment of the invention is shown in Figures 1 and 2 and is fabricated using the self-aligned silicide process. The illustrated integrated circuit has a p-type well 2 formed by diffusion on the main surface of an n-type semi-conductor substrate 1, gate electrodes $G_p$ and $G_n$, each formed on the n-type semi-conductor substrate 1 and the p-type well 2 via gate insulation films 21, a p-type source/drain region $3_p$ and an n-type source/drain region $3_n$ formed in a self aligned manner by masking the gate electrode $G_p$ and the gate electrode $G_n$, a channel stopper $4_p$ heavily doped with p-type impurity formed within the p-type well 2 for preventing parasitic MOS and a channel stopper $4_n$ heavily doped with n-type impurity formed on the n-type semi-conductor substrate 1 for preventing latch up. The gate electrodes $G_p$, $G_n$ formed by the self-aligned silicide process each comprise a polycrystalline silicon film 22 and a film of a high melting point metal disilicide 23, such as $TiSi_2$ - (titanium disilicide), and a film of high melting point metal disilicide 10 is formed on the surfaces of the source/drain regions $3_p$, $3_n$, the channel stoppers $4_p$ and $4_n$ and the other diffusion regions.

The structure of the protective resistor $R_1$ of the p-channel MOS transistor $T_p$ comprises an aluminium wire 24 in conductive contact with the channel stopper $4_n$ through a contact hole 24a and connected with the power supply potential $V_{dd}$, a contact region 25 heavily doped with n-type impurity formed in the semi-conductor substrate 1 at a position isolated from the contact hole 24a thereof, and an aluminium wire 26 in conductive contact with the contact region 25 through a contact hole 26a and electrically connected with the gate electrode $G_p$. The resistance region of the protective resistor $R_1$ is substantially a local, unbounded region of the semi-conductor substrate 1 sandwiched between the channel stopper $4_n$ and the contact region 25.

On the other hand, the structure of the protective resistor $R_2$ of the n-channel MOS transistor $T_n$ comprises an aluminium wire 27 in conductive contact with the channel stopper $4_p$ through a contact hole 27a and connected with the ground potential $V_{ss}$, a contact region 28 heavily doped with p-type impurity formed in the p-type well 2 at a position isolated from the contact hole 27a thereof, and an aluminium wire 29 in conductive contact with the contact region 28 through a contact hole 29a and electrically connected with the gate electrode $G_n$. The resistance region of the protective resistor $R_2$ is substantially a local, unbounded region of the p-type well 2 sandwiched between the channel stopper $4_p$ and the contact region 28.

While the surfaces of the diffusion regions according to the self-aligned silicide process are formed with the high melting point metal disilicide film 10, no high melting point metal disilicide film is formed on the surfaces of the semi-conductor substrate 1 and the p-type well 2. Moreover, the impurity contents of the semi-conductor substrate 1 and the p-type well 2 are lower than those of the channel stoppers $4_n$, $4_p$. As a result, the protective resistors $R_1$, $R_2$ exhibit large resistance values. Because of these large resistance values, the gate insulation film 21 is protected from breakdown due to power turn on noise or to surge voltages. The position at which the contact regions 25, 28 are formed can be selected with relative freedom. As the contact regions 25, 28 are themselves small and the resistance regions are local regions of the semi-conductor substrate 1 and the p-type well 2, it becomes possible to use what would otherwise be empty space.

In the process of fabricating the integrated circuit having these protective resistors, it is possible to form the contact regions 25, 28 and the channel stoppers $4_p$, $4_n$ at the same time as the source/drain regions $3_p$, $3_n$. It thus suffices to modify only the mask pattern.

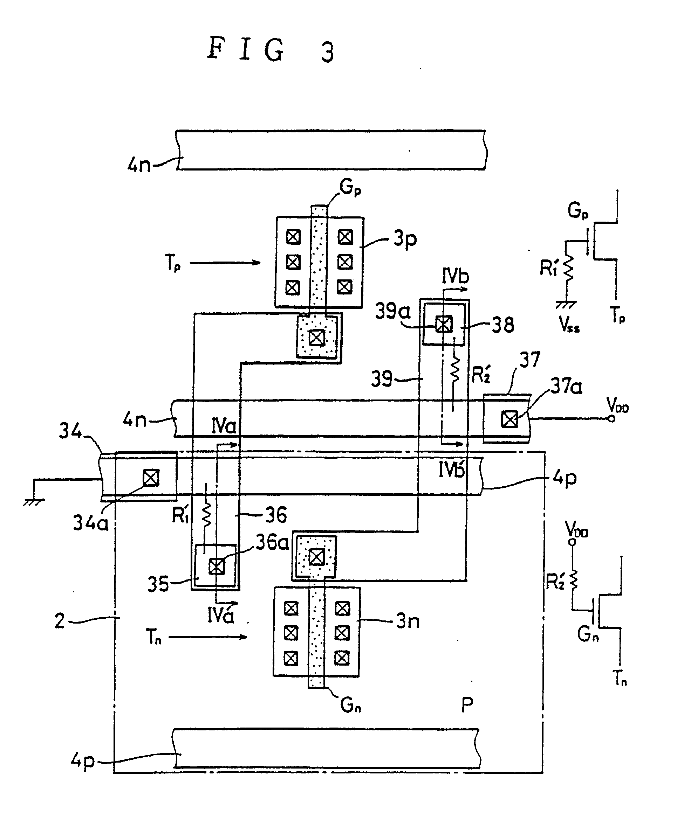

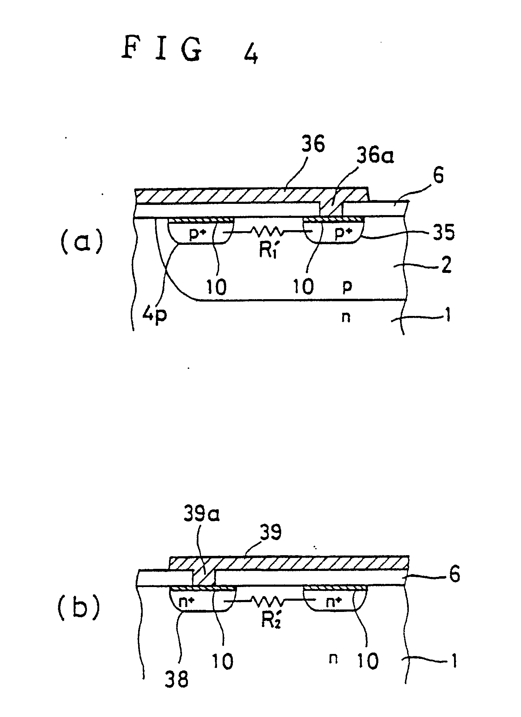

A second embodiment of the integrated circuit having an MIS transistor according to this invention is illustrated in Figures 3 and 4. In this embodiment, the gate electrode $G_p$ of the p-channel MOS transistor $T_p$ is pull-down connected with the ground potential $V_{ss}$ through a protective resistor $R_1'$, and the gate $G_n$ of the n-channel MOS transistor $T_n$ is connected with the power supply potential $V_{dd}$ through a protective resistor $R_2'$.

The structure of the protective resistor $R_1'$ of the p-channel MOS transistor $T_p$ comprises an aluminium wire 34 in conductive contact with the channel stopper $4_p$ through a contact hole 34a and connected with the ground potential $V_{ss}$, a contact region 35 heavily doped with p-type impurity formed in the p-type well 2 at a position isolated from the contact hole 34a thereof, and an aluminium wire 36 in conductive contact with the contact region 35 through a contact hole 36a and electrically connected with the gate electrode $G_p$. The

resistance region of the protective resistor $R_1{'}$ is substantially a local, unbounded region of the p-type well 2 sandwiched between the channel stopper $4_p$ and the contact region 35.

On the other hand, the structure of the protective resistor $R_2{'}$ of the n-channel MOS transistor $T_n$ comprises an aluminium wire 37 in conductive contact with the channel stopper $4_n$ through a contact hole 37a and connected with the power supply potential $V_{dd}$, a contact region 38 heavily doped with n-type impurity formed in the semi-conductor substrate 1 at a position isolated from the contact hole 37a thereof, and an aluminium wire 39 in conductive contact with the contact region 38 through a contact hole 39a and electrically connected with the gate electrode $G_n$. The resistance region of the protective resistor $R_2{'}$ is substantially a local, unbounded region of the semi-conductor substrate 1 sandwiched between the channel stopper $4_n$ and the contact region 38.

As in the case of the first embodiment of the invention, the structure of the gate input protective resistors $R_1{'}$, $R_2{'}$ according to this second embodiment takes advantage of the fact that the impurity contents of the semi-conductor substrate 1 and the p-type well 2 are low, notwithstanding that the integrated circuit is fabricated using the self-aligned silicide process. Since high resistance values can thus be established for the protective resistors $R_1{'}$, $R_2{'}$, the gate insulation film can effectively be protected from breakdown.

As described, the present invention relates to an integrated circuit in which the gate electrode of an MIS transistor is connected to the power supply potential through a protective resistor, and relates particularly to such an integrated circuit in which the protective resistor does not constitute a diffusion resistor formed as an island like diffusion region within the semi-conductor substrate or the well but substantially comprises an unbounded local region within the semi-conductor substrate or the well. As a result of this structure, the integrated circuit according to the invention exhibits the following advantages:-

(1) Since the protective resistor comprises a local region within the relatively low impurity semi-conductor substrate or well, it is possible to establish the resistance of the protective resistor at a high value. In particular, it is possible, even in an integrated circuit fabricated using a process, such as the self-aligned silicide process, which lowers the resistance of the diffusion regions, to provide a protective resistor which does not suffer from reduced resistance. It is, therefore, possible to realise a protective resistor with a sufficiently large resistance value that it becomes possible to protect the gate insulation film from breakdown by power supply noise or the like. While a gate electrode fabricated using the self-aligned silicide process has an extremely low breakdown voltage, the aforesaid structure makes it possible to establish a resistance value which is sufficiently high for protecting such a gate from breakdown.

(2) Where the channel stopper serves also as the first contact region, the area that would otherwise be used exclusively for one of the protective resistor electrodes can be saved, thus contributing to size reduction and high packing density. Since, for the second contact region, it suffices to secure an area in which a single contact hole can be formed and since the position of this contact hole requires only to be isolated from that of the first contact hole, there is relatively more freedom than heretofore in positioning the second contact region utilising any free space.

(3) The number of steps in the process for fabricating the integrated circuit is not increased since the first and second contact regions can be formed using the step for forming the source/drain region.

(4) Although each year sees a stronger demand for integrated circuits with higher packing densities made possible by finer component features, reduction of component size has the effect of reducing component current conduction capability, which in turns leads to decreased operating speed. Integrated circuits fabricated using the self-aligned silicide process are well suited to future needs since their lower contact resistance and diffusion resistance enable them to exhibit high operating speeds even with finer component features. Where such an integrated circuit is constructed such that its gate electrodes are connected with the power supply potential, however, its components become susceptible to breakdown in proportion as the pull-up or pull-down resistance is reduced by the reduction in feature size and the application of the self-aligned silicide process. When the arrangement according to the present invention is employed, however, it becomes possible to realise an integrated circuit that has high resistance against breakdown from noise and surge voltages. This effect is particularly prominent when the invention is applied to micro-processors and memory devices.

## Claims

1. An integrated circuit having at least one MIS transistor ($T_n$, $T_p$) in which a gate electrode ($G_n$, $G_p$) is arranged to be connected to a power supply potential ($V_{dd}$, $V_{ss}$) through a protective resistor ($R_1$,

$R_2$), characterised by a first contact diffusion region ($4_n$, $4_p$) formed within a semi-conductor substrate (1) or within a well (2) in the semi-conductor substrate and arranged to make contact with the power supply potential, and a second contact diffusion region (25, 28, 35, 38) formed within the semiconductor substrate or the well at a position isolated from the first contact diffusion region and arranged in electrical contact with the gate electrode, the region of the semi-conductor substrate or well between the first and second contact diffusion regions substantially constituting a resistance region of the protective resistor.

2. An integrated circuit according to claim 1 characterised in that the surfaces of the first and second contact diffusion regions are formed with a metal silicide film (10) produced by means of a self-aligned silicide process.

3. An integrated circuit according to claim 1 or 2 characterised in that the first contact diffusion region is a channel stopper.

4. An integrated circuit having at least two MIS transistors ($T_n$, $T_p$), one of which is transistor of the first conductivity type and the other of which is an MIS transistor of a second conductivity type, the gate electrodes ($G_n$, $G_p$) of the two MIS transistors being arranged to be electrically connected with a power supply potential ($V_{dd}$, $V_{ss}$) through protective resistors ($R_1$, $R_2$) characterised by a first conductivity type first contact diffusion region ($4_n$) formed within a first conductivity type semi-conductor substrate (1) and arranged to make contact with the power supply potential, a second conductivity type first contact diffusion region ($4_p$) formed within a second conductivity type well (2) in the semi-conductor substrate and arranged to make contact with the power supply potential, a first conductivity type second contact diffusion region (25) formed within the semi-conductor substrate at a position isolated from the first conductivity type first contact diffusion region and making electrical contact with the gate electrode of the second conductivity type MIS transistor, and a second conductivity type second contact diffusion region (28) formed within the well at a position isolated from the second conductivity type first contact diffusion region and making electrical contact with the gate electrode of the first conductivity type MIS transistor, that region of the semi-conductor substrate between the first conduc-tivity type first and second contact diffusion regions substantially constituting a resistance region of the protective resistor connected to the gate electrode of the second conductivity type MIS transistor, and that region of the well between the second conductivity type first and second contact diffusion regions substan-tially constituting a resistance region of the protective resistor connected to the gate electrode of the first conductivity type MIS transistor.

5. An integrated circuit having at least two MIS transistors ($T_n$, $T_p$) one of which is an MIS transistor of a first conductivity type and the other of which is an MIS transistor of a second conductivity type, the gate electrodes ($G_n$, $G_p$) of the two MIS transistors being arranged to be electrically connected with a power supply potential ($V_{dd}$, $V_{ss}$) through protective resistors ($R_1$, $R_2$), characterised by a first conductivity type first contact diffusion region ($4_n$) formed within a first conductivity type semi-conductor substrate (1) and arranged to make contact with the power supply potential, a second conductivity type first contact diffusion region ($4_p$) formed within a second conductivity type well (2) in the semi-conductor substrate and arranged to make contact with the power supply potential, a first conductivity type second contact diffusion region (38) formed within the semi-conductor substrate at a position isolated from the first conductivity type first contact diffusion region and making electrical contact with the gate electrode of the first conductivity type MIS, and a second conductivity type second contact diffusion region (35) formed within the well at a position isolated from the second conductivity type first contact diffusion region and making electrical contact with the gate electrode of the second conductivity type MIS transistor, that region of the semi-conductor substrate between the first conductivity type first and second contact diffusion regions substantially constituting a resistance region of the protective resistor connected to the gate electrode of the first conductivity type MIS transistor, and that region of the well between the second conductivity type first and second contact diffusion regions substantially constituting a resistance region of the protective resistor connected to the gate electrode of the second conductivity type MIS transistor.

6. An integrated circuit according to claim 4 or 5 characterised in that the surfaces of the first and second contact diffusion regions are formed with a metal silicide film (10) produced by means of a self-aligned silicide process.

7. An integrated circuit according to any of claims 4 to 6 characterised in that the first and second contact diffusion regions are channel stoppers.

# F I G 1

FIG 2

(a)

(b)

(c)

(d)

# F I G 3

# F I G  4

(a)

(b)

# F I G 5

(a)

(b)